# EUROPEAN PATENT APPLICATION

(11) **EP 4 411 834 A1**
(43) Date of publication of application: **07.08.2024**
(21) Application number: 22874971.9
(22) Date of filing: 28.09.2022
(51) Int. Cl.: H01L 31/05, H01L 31/048

(54) **PHOTOVOLTAIC CELL ASSEMBLY AND MANUFACTURING METHOD THEREFOR**

(30) Priority: 28.09.2021 CN 202111146524
(71) Applicant: Cando-Solarphotoelectric Technology (Changzhou) Co., Ltd, Changzhou City, Jiangsu 213000 (CN)
(72) Inventor: HUANG, Yaolun, hangzhou, Jiangsu 213000 (CN)
(74) Representative: Ridderbusch, Oliver
(86) International application number: PCT/CN2022/122050
(87) International publication number: WO 2023/051587

(57) **Abstract**

The present invention relates to a photovoltaic cell module and a manufacturing method thereof. The photovoltaic cell module includes n1 photovoltaic generating groups, each photovoltaic generating group includes n2 photovoltaic cell units arranged in a second direction, the photovoltaic cell units within each photovoltaic generating group are positioned between two photovoltaic conductive strips, the two photovoltaic conductive strips have discontinuous points, which are used to change the series-parallel connection between the photovoltaic cell units within the photovoltaic generating group. The manufacturing method of module includes the steps of firstly making the photovoltaic cell unit, then typesetting the photovoltaic cell unit, the photovoltaic conductive strip, the front panel and the rear panel, next making a photovoltaic cell module through lamination. The beneficial effect of the present invention is that adjusting the positions of discontinuous points and the upward-downward position and forward-backward direction of the photovoltaic cell string during type-setting enables the electrical performance parameters and series-parallel setting of the photovoltaic module to ease adjusting, so as to achieve flexible manufacturing. The photovoltaic cell strings are interconnected with each other through metallic foil conductive trips, especially through flexible flat cables, so that it is possible to make low-costs and flexible foldability a reality.

## Description

### TECHNICAL FIELD

The present invention relates to the technical field of photovoltaics, in particular a photovoltaic cell module and a manufacturing method thereof.

### BACKGROUND ART

With the attention paid to the climate crisis at home and abroad, all countries have put forward specific schedules for the target of "peaking carbon dioxide emissions" and "carbon neutrality". Photovoltaic products have rapidly converted from application in large-scale power stations to distributed application, and accelerated their integration with civil life scenarios such as buildings and electric vehicles. Internationally, the International Energy Agency (IEA) has organized global technical experts and established a joint working group for the integration with buildings and new energy vehicles. In China, the Energy Bureau of the National Development and Reform Commission puts forward the idea of "promoting all over the county", which has also greatly accelerated the integration of photovoltaics with civil life scenarios.

New application scenarios for photovoltaics urgently need flexibly manufacturing photovoltaic products and flexible and lightweight photovoltaic products, moreover, higher requirements are put forward for products with reliability, ease to use and cost performance.

The manufacturing process of existing photovoltaic modules is as follows: two photovoltaic cells are connected through metal wires by ways of antarafacial interconnection. A Z-shaped metal wire is used to connect an exposal surface of a first cell (positive electrode) to a shadow surface of a second cell (negative electrode), and an exposal surface of the second cell (positive electrode) to a shadow surface of a third cell (negative electrode). Continually repeating this process enables the photovoltaic cells to be connected into a string. Next, the cells are assembled by ways of string connection and series-parallel connection, and added with encapsulants for encapsulation and lamination, finally achieving manufacturing modules.

If the existing photovoltaic module needs to change its electrical performance parameters and series-parallel setting-up, the time for switching a production line is generally more than 8 hours, without the capability to achieve the customized flexible manufacture.

In addition, the existing photovoltaic cell string can only enable a string connection of 2-3 cells once, so its production efficiency is low.

In the mode of the existing photovoltaic cell string, welding a 100-160µm wafer severely brings about fragments. This type of welding fragments mainly derives from collision or stress during the welding process. Because the same welding strip should appear on the exposal surface and shadow surface of the photovoltaic module, and the action to physically arrange the welding strip in the series welding process needs to be constantly staggered with the action to arrange the photovoltaic cells, in the welding process, it is easy to destroy the photovoltaic cells with the welding strip in the process of heat expansion and contraction of the photovoltaic cells.

Furthermore, it is difficult to ensure the reliability of the existing photovoltaic flexible modules for multi-time folding, and that will result in high costs in implementation.

At present, the flexible modules on the market are mostly quasi-flexible modules, which do not have the ability to bend in large curvature many times. As with a photovoltaic panel disclosed in the CN 104 038 142 B, a conventional tinned copper strip is used between the cells of such modules to achieve a connection between photovoltaic cells. A similar condition exists in thin-film batteries, such as a CIGS battery disclosed by miasole company in US 2021 0 217 913 A1, which is also electrically connected through coated Cu wires. This connection does not have the ability to bend many times. Discovered in the inventor's experiment, in the case that a conventional tin-coated welding strip is bent by about 90 degrees, it will generally be broken after 30-45 time folding. This is a problem faced by most flexible modules.

The patent CN 102 945 873 B discloses that ways such as adding a wire groove enable the wire to relax to a certain extent, so as to improve folding performance, it is said that it can be folded more than 4,000 times. This method also increases the costs of manufacturing; however, it is still difficult to guarantee the performance of each product. As disclosed in the text of the patent CN 110 140 448 B by the same inventor, technical problems such as disconnection, expansion and difficulty in folding of connecting wires for solar cell chips may still occur in the product folded many times.

The patent CN 110 140 448 B discloses a military photovoltaic system that uses a flexible conductive wafer (such as a Cu wafer) to strengthen the connection between cell modules, so as to improve reliability. However, this method is highly costed and difficult to be applied for civil use, not to mention large-scale application to the integration of photovoltaics with building or the mobile photovoltaic field of electric vehicles.

### SUMMARY OF THE INVENTION

The technical problem to be solved by the present invention is that the existing photovoltaic module cannot realize flexible manufacturing.

The Further technical problem is that it is difficult to ensure the reliability of the existing flexible photovoltaic modules for multi-time folding, and that will result in high costs in implementation.

In order to solve the above technical problem, the technical solution of the present invention is as follows: a photovoltaic cell module comprising a front panel, a rear panel and a photovoltaic cell layer encapsulated between the front panel and the rear panel, wherein the photovoltaic cell layer includes n1 photovoltaic generating groups, each photovoltaic generating group includes n2 photovoltaic cell units arranged in a second direction, the current in the photovoltaic cell unit flows in the first direction perpendicular to the second direction after converging, each photovoltaic generating group is interconnected with each other and leads out current through two upward and downward photovoltaic conductive strips, the two photovoltaic conductive strips are arranged in parallel and stretch in the second direction, the photovoltaic cell units within each photovoltaic generating group are positioned between the two photovoltaic conductive strips, and the two ends of the photovoltaic cell unit are respectively connected with the two photovoltaic conductive strips, the photovoltaic generating groups are interconnected with each other and leads out current through the photovoltaic conductive strip, the two photovoltaic conductive strips of the photovoltaic generating group have discontinuous points, which are used to change the series-parallel connection between the photovoltaic cell units within the photovoltaic generating group, where n1≥1, n2≥1.

As further defined, the photovoltaic cell unit is a photovoltaic cell string, which is formed by photovoltaic cells welded in series through an interconnecting main gate line, the interconnecting main gate line on one surface of the photovoltaic cells at both ends of the photovoltaic cell string backwards facing a corresponding photovoltaic conductive strip stretches to the outside of the photovoltaic cell string, the interconnecting main gate line on the other surface of the photovoltaic cells at both ends of the photovoltaic cell string frontwards facing a corresponding photovoltaic conductive strip is positioned inside the photovoltaic cell string, one end of the photovoltaic cell string with the connecting portion of the corresponding photovoltaic conductive strip is positioned at the interconnecting main gate line stretching from this end, the other end of the photovoltaic cell string with the connecting portion of the corresponding photovoltaic conductive strip is positioned on the surface of the extreme photovoltaic cell of this end;
or the photovoltaic cell unit is a photovoltaic cell string, which is formed by the photovoltaic cells welded in series through imbricating or imbricate welding, one end of the photovoltaic cell string is connected with the photovoltaic conductive strip through the electrode of the exposal surface of the extreme photovoltaic cell of this end, the other end of the photovoltaic cell string is connected with the photovoltaic conductive strip through the electrode of the shadow surface of the extreme photovoltaic cell of this end.

As further defined, the photovoltaic cell in the photovoltaic cell string is made up of small photovoltaic cells divided into by a photovoltaic cell.

As further defined, when n1≥2, the photovoltaic generating groups inside the photovoltaic cell layer are arranged in the first direction, and each photovoltaic cell unit in the photovoltaic generating group is aligned in a row with the photovoltaic cell units at the corresponding position inside other photovoltaic generating groups in the first direction.

As further defined, the module further includes a bypass diode, which is connected to the photovoltaic generating group through the photovoltaic conductive strip.

As further defined, when n1=1, the outside of the photovoltaic conductive strip on one side of the photovoltaic generating group is further provided with a third photovoltaic conductive strip stretching in the second direction, and the bypass diode and a vertical photovoltaic conductive strip stretching in the first direction are connected between the third photovoltaic conductive strip and the photovoltaic conductive strip on the same side, the bypass diode and the vertical photovoltaic conductive strip are aligned with the adjacent photovoltaic cell units in the first direction, the third photovoltaic conductive strip enables the bypass diode to connect to the photovoltaic generating group through its own discontinuous point and the vertical photovoltaic conductive strip stretching in the first direction, the two ends of the photovoltaic conductive strip on the same side as the third photovoltaic conductive strip are positive and negative lead-out ends, the photovoltaic cell module is a flexible module, the front panel and the rear panel are made from flexible material, and the photovoltaic conductive strip stretching in the second direction is a metal foil conductive strip or a conductive paste tape or a flexible flat cable; or all the photovoltaic conductive strips are a metal foil conductive strip or a conductive paste tape or a flexible flat cable.

As further defined, the photovoltaic cell layer is encapsulated between the front panel and the rear panel through an encapsulation adhesive layer, and the photovoltaic conductive strip is compounded on the encapsulation adhesive layer on the same side; or the photovoltaic conductive strip is compounded on the front panel or the rear panel on the same side, the encapsulation adhesive layer has a dodging hollow, and the photovoltaic cell unit and the photovoltaic conductive strip are connected with each other through the dodging hollow.

As further defined, the photovoltaic cell unit and the photovoltaic conductive strip form a mechanical and electrical connection through low-temperature welding material and low-temperature curing conductive paste, the welding temperature of the low-temperature welding material matches the lamination temperature of the photovoltaic module, and the curing temperature of the low-temperature curing conductive paste matches the lamination temperature of the photovoltaic module.

To ensure the flexibility of photovoltaic modules and the reliability of multi-time folding of flexible photovoltaic modules, further, the photovoltaic cell module is a flexible module, the front panel and the rear panel are made from flexible material, and the photovoltaic conductive strip is a metal foil conductive strip or a conductive paste tape or a flexible flat cable.

As further defined, the metal foil conductive strip is a copper foil strip or aluminum foil strip of which the surface is covered with a 5-100µm thick low-temperature welding material layer, and the flexible flat cable is an FFC cable, FPC cable or PTF cable of which the surface is covered with a low-temperature welding material layer, the welding temperature of the low-temperature welding material layer matches the lamination temperature of the photovoltaic module.

As further defined, the module is divided into a plurality of rigid minimum folding units arranged in the second direction, each photovoltaic cell unit of each photovoltaic generating group is located in one minimum folding unit, and there is a folding gap between the minimum folding units.

As further defined, the minimum folding unit is formed by ways of covering a rigid protective plate on one side of the exposal surface of the photovoltaic cell unit, and the rigid protective plate and the photovoltaic cell unit are combined together through the encapsulation adhesive layer between them, or the minimum folding unit is formed by ways of covering a protective layer of glue-drop material on one side of the exposal surface of the photovoltaic cell unit.

A manufacturing method of the photovoltaic cell module, comprising the steps of firstly making a photovoltaic cell unit, then typesetting a photovoltaic cell unit, a photovoltaic conductive strip, a front panel and a rear panel, next making the photovoltaic cell module through lamination, completing the electrical connection between the photovoltaic cell unit and the photovoltaic conductive strip during lamination, under the action of lamination temperature and pressure, combining the connecting portions of the photovoltaic cell unit and the photovoltaic conductive strip with each other, forming a mechanical and electrical connection through low-temperature welding material or low-temperature curing conductive paste, the low-temperature welding material or the low-temperature curing conductive paste being inherent in the connecting portions of the photovoltaic cell unit and the photovoltaic conductive strip or being placed on the connecting portion during typesetting, or the steps of firstly making a photovoltaic cell unit, then typesetting a photovoltaic cell unit and a photovoltaic conductive strip and pre-welding to form a semi-finished product, next typesetting the semi-finished product, a rear panel and a front panel, next making the photovoltaic cell module through lamination.

As further defined, when the photovoltaic cell unit is a photovoltaic cell string, the photovoltaic cell string is formed by photovoltaic cells welded in series through interconnecting main gate lines, the interconnecting main gate line on one surface of the photovoltaic cells at both ends of the photovoltaic cell string backwards facing a corresponding photovoltaic conductive strip stretches to the outside of the photovoltaic cell string, the interconnecting main gate line on the other surface of the photovoltaic cells at both ends of the photovoltaic cell string frontwards facing a corresponding photovoltaic conductive strip is positioned inside the photovoltaic cell string, one end of the photovoltaic cell string with the connecting portion of the corresponding photovoltaic conductive strip is positioned at the interconnecting main gate line stretching from this end, the other end of the photovoltaic cell string with the connecting portion of the corresponding photovoltaic conductive strip is positioned on the surface of the extreme photovoltaic cell of this end; adjusting the upward-downward position of the photovoltaic cell string in the first direction and/or the position of the discontinuous point during typesetting enables diverse circuit connections to form between the photovoltaic cell strings;
or when the photovoltaic cell unit is a photovoltaic cell string, the photovoltaic cell string is formed by the photovoltaic cells welded in series through imbricating or imbricate welding, one end of the photovoltaic cell string is connected with the photovoltaic conductive strip through the electrode of the exposal surface of the extreme photovoltaic cell of this end, the other end of the photovoltaic cell string is connected with the photovoltaic conductive strip through the electrode of the shadow surface of the extreme photovoltaic cell of this end, adjusting the forward-backward orientation of the photovoltaic cell string and/or the position of the discontinuous point during typesetting enables diverse circuit connections to form between the photovoltaic cell strings.

As further defined, after welding the photovoltaic cells into a string, fragmentation is carried out in the first direction, a big photovoltaic cell string is divided into independent small photovoltaic cell strings, leaving the small photovoltaic cell strings for use in the subsequent step of typesetting.

The beneficial effect of the present invention is that adjusting the positions of discontinuous points and the upward-downward position and forward-backward direction of the photovoltaic cell string during type-setting enables the electrical performance parameters and series-parallel setting-up of the photovoltaic module to ease adjusting, so as to achieve flexible manufacturing.

The photovoltaic cell units are designed to be interconnected through the upward and downward photovoltaic conductive strips, so that the number of the used photovoltaic conductive strips decreases to achieve low costs of the photovoltaic conductive strips in the industry and reduce the costs of modules.

The photovoltaic cell strings are interconnected with each other through metallic foil conductive trips and conductive paste tapes, especially through flexible flat cables, so that it is possible to make a flexible connection between photovoltaic cells, thereby enabling crystalline silicon modules to be folded with high reliability and low costs. In fact, in the application for mobile phones, flexible flat cables such as FPC or PTF or FFC and circuit boards can already achieve mass production for the products capable of being reliably folded 80,000 times. It is expected that the flexible photovoltaic module of the present invention can also realize more than 80,000-times folding, therefore, it is possible to manufacture the highly-reliable products with photovoltaic crystalline silicon cells and thin-film cell modules that can be folded and winded.

The photovoltaic cells inside the module can be connected together into a string or in a whole board through the interconnecting main gate lines by ways of interconnection on the same surface, and then cut into required individual photovoltaic cell units, greatly improving production efficiency.

In addition, this design avoids the interconnecting main gate lines from concurrently connecting the exposal surface and the shadow surface of adjacent photovoltaic cells, greatly lowering the occurrence of fragments, raising the non-defective ratio of module manufacturing and reducing costs. It is of great significance for the application of thinning a high-efficient cell.

### BRIEF DESCRIPTION OF THE DRAWINGS

The present invention is further described in combination with the drawings and examples as follows.
FIG. 1 is a front-state structure schematic diagram of Example 1 according to the present invention.
FIG. 2 is an outline of Example 1 according to the present invention.
FIG. 3 is a front-state structure schematic diagram of Example 2 according to the present invention.
FIG. 4 is an outline of Example 2 according to the present invention.
FIG. 5 is a side-state structure schematic diagram of Example 4 according to the present invention.
FIG. 6 is an outline of Example 10 according to the present invention.
FIG.7 is a structure diagram showing that the photovoltaic cell strings are interconnected with each other through the photovoltaic conductive strips in Example 11 according to the present invention.
FIG. 7a is a schematic diagram of adjusting the two-ends orientation of the photovoltaic cell string in Example 11 according to the present invention to change the circuit connection.
FIG.8 is a structure diagram showing that the photovoltaic cell strings are interconnected with each other through the photovoltaic conductive strips in Example 12 according to the present invention.
FIG. 8a is a schematic diagram of adjusting the two-ends orientation of the photovoltaic cell string in Example 12 according to the present invention to change the circuit connection.

Where, 1-front panel; 2-rear panel; 3-photovoltaic cell string; 3-1-photovoltaic cell; 4-; 5-photovoltaic conductive strip; 5-1-third photovoltaic conductive strip; 5-2-vertical photovoltaic conductive strip; 6-discontinuous point; 7-bypass diode; 8-rigid protective plate; 9-encapsulation adhesive layer.

### DETAILED DESCRIPTIONS OF THE PREFERRED EMBODIMENTS

### EXAMPLE 1

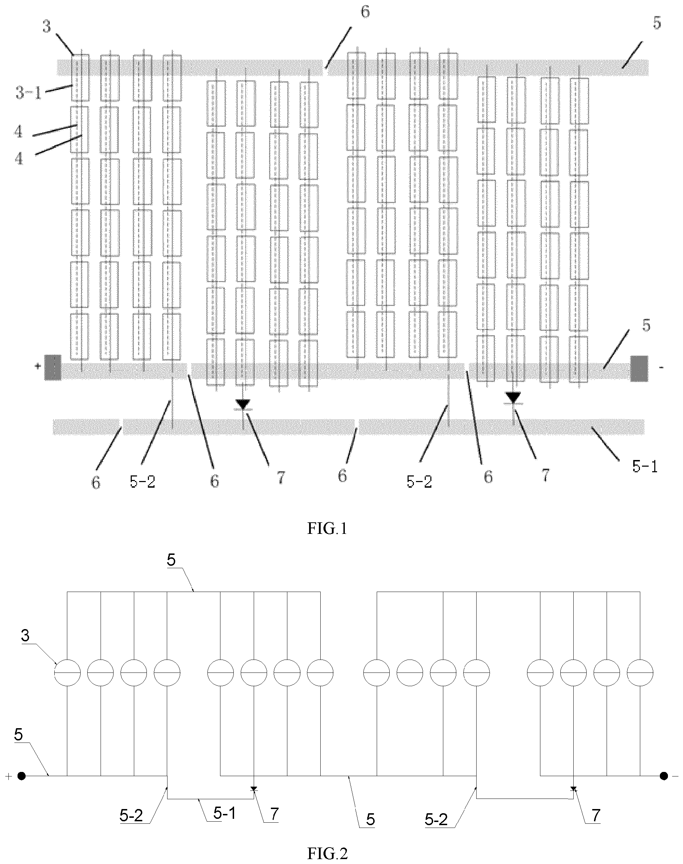

As shown in FIGs. 1-2, a photovoltaic cell module includes the front panel 1, the rear panel 2 and the photovoltaic cell layer encapsulated between the front panel 1 and the rear panel 2, the photovoltaic cell layer includes n1 photovoltaic generating groups, each photovoltaic generating group includes n2 photovoltaic cell units arranged in a second direction, the photovoltaic cell unit is the photovoltaic cell string 3, the photovoltaic cell 3-1 inside the photovoltaic cell string 3 is arranged in a first direction perpendicular to the second direction, the current in the photovoltaic cell string 3 flows in the first direction after converging, each photovoltaic generating group is interconnected with each other and leads out current through two upward and downward photovoltaic conductive strips 5, the two photovoltaic conductive strips 5 are arranged in parallel and stretch in the second direction, the photovoltaic cell strings 3 within each photovoltaic generating group are positioned between the two photovoltaic conductive strips 5, and the two ends of the photovoltaic cell string 3 are respectively connected with the two photovoltaic conductive strips 5, the two photovoltaic conductive strips 5 have discontinuous points 6, which are used to change the series-parallel connection between the photovoltaic cell strings 3 within the photovoltaic generating group, where n1=1, n2=16.

As shown in FIG. 1, the photovoltaic cell string 3 is formed by the photovoltaic cells 3-1 welded in series through the interconnecting main gate lines 4 interconnected on the same surface, the interconnecting main gate line 4 on one surface of the photovoltaic cells 3-1 at both ends of the photovoltaic cell string 3 backwards facing a corresponding photovoltaic conductive strip 5 stretches to the outside of the photovoltaic cell string 3, the interconnecting main gate line 4 on the other surface of the photovoltaic cells 3-1 at both ends of the photovoltaic cell string 3 frontwards facing a corresponding photovoltaic conductive strip 5 is positioned inside the photovoltaic cell string 3, one end of the photovoltaic cell string 3 with the connecting portion of the corresponding photovoltaic conductive strip 5 is positioned at the interconnecting main gate line 4 stretching from this end, the other end of the photovoltaic cell string 3 with the connecting portion of the corresponding photovoltaic conductive strip 5 is positioned on the surface of the extreme photovoltaic cell 3-1 of this end. Specifically, the two upward and downward photovoltaic conductive strips 5 of the interconnected photovoltaic generating group are both positioned on one side of the shadow surface of the photovoltaic cell string 3. The exposal surface and the shadow surface of the photovoltaic cell string 3 are both interconnected on the same surface through one interconnecting main gate line 4, and the interconnecting main gate lines 4 of the exposal surface and the shadow surface are staggered with each other. The two ends of the interconnecting main gate line 4 of the exposal surface of the photovoltaic cell string 3 stretches to the outside of the photovoltaic cell string 3, the two ends of the interconnecting main gate line 4 of the shadow surface of the photovoltaic cell string 3 are both positioned inside the photovoltaic cell string 3, one end of the photovoltaic cell string 3 is welded with the corresponding photovoltaic conductive strip 5 through the interconnecting main gate line 4 stretching out, and the other end of the photovoltaic cell string 3 is welded with the corresponding photovoltaic conductive strip 5 through the electrode on the shadow surface of the extreme photovoltaic cell 3-1 of this end.

In order to protect the photovoltaic cell string in the photovoltaic generating group, the present invention further includes the bypass diode 7, which is connected to the photovoltaic generating group through the photovoltaic conductive strip 5.

Specifically, the outside of the photovoltaic conductive strip 5 on one side of the photovoltaic generating group is further provided with the third photovoltaic conductive strip 5-1 stretching in the second direction, and the bypass diode 7 and the vertical photovoltaic conductive strip 5-2 are connected between the third photovoltaic conductive strip 5-1 and the photovoltaic conductive strip 5 on the same side, both the bypass diode 7 and the vertical photovoltaic conductive strip 5-2 stretch in the first direction, the bypass diode 7 and the vertical photovoltaic conductive strip 5-2 are aligned with the adjacent photovoltaic cell strings in the first direction, the third photovoltaic conductive strip 5-1 enables the bypass diode 7 to connect to the photovoltaic generating group through its own discontinuous point 6 and the vertical photovoltaic conductive strip 5-2, the two ends of the photovoltaic conductive strip 5 on the same side as the third photovoltaic conductive strip 5-1 are positive and negative lead-out ends.

The photovoltaic cell module is a flexible module, the front panel 1 and the rear panel 2 are made from flexible material, and the photovoltaic conductive strip 5 stretching in the second direction is a metal foil conductive strip or a flexible flat cable. When the vertical photovoltaic conductive strip 5-2 is aligned with the adjacent photovoltaic cell unit in the first direction, the vertical photovoltaic conductive strip 5-2 is not subject to its bending resistance due to avoidance of bending action, the vertical photovoltaic conductive strip 5-2 may be a metal wire, welding strip, etc., and welded between the third photovoltaic conductive strip 5-1 and the photovoltaic conductive strip 5 on the same side. The length direction of the flexible photovoltaic cell module is the second direction.

The metal foil conductive strip is a copper foil strip or aluminum foil strip of which the surface is covered with a 5-100µm thick welding material layer, and the flexible flat cable is a FFC cable, a FPC cable or a PTF cable of which the surface is covered with a welding material layer.

A manufacturing method of a photovoltaic cell module includes the following steps.

S1. Making the photovoltaic cell string 3, specifically, after welding the photovoltaic cells 3-1 into a string, fragmenting in the first direction by ways of mechanically splintering (specifically, for the photovoltaic cell 3-1, forming a laser scratch having a certain deep on the surface of the silicon wafer before texturing, at the time of mechanically splintering, enabling the cell to fragment along the mechanically-fragile points of the scratch), dividing a big photovoltaic cell string 3 into independent small photovoltaic cell strings 3, leaving the small photovoltaic cell strings 3 for use in the subsequent step.

S2. Firstly typesetting the photovoltaic cell string 3 and the photovoltaic conductive strip 5, adjusting the upward-downward position of the photovoltaic cell string 3 in the first direction and/or the position of the discontinuous point 6 during typesetting, enabling the discontinuous point 6 to form by ways of punching shear on the photovoltaic conductive strip 5, forming diverse circuit connections between the photovoltaic cell strings 3, next pre-welding the photovoltaic cell string 3 and the bypass diode 7 with the photovoltaic conductive strip 5 to form a semi-finished product.

S3. Then typesetting the rear panel 2, the encapsulation adhesive layer 9, the semi-finished product prepared in S2, the encapsulation adhesive layer 9, and the front panel 1 in proper order, wherein the rear panel 2 is PET or TPT, the encapsulation adhesive layer 9 is EVA or POE or PVB, and the front panel 1 is FRP or ETFE.

S4. Making a photovoltaic cell module through lamination.

In Example 1, when the photovoltaic conductive strip 5 is a flexible flat cable, the discontinuous point may be inherent the flexible flat cable, it is formed in the manufacturing process of the flexible flat cable.

### EXAMPLE 2

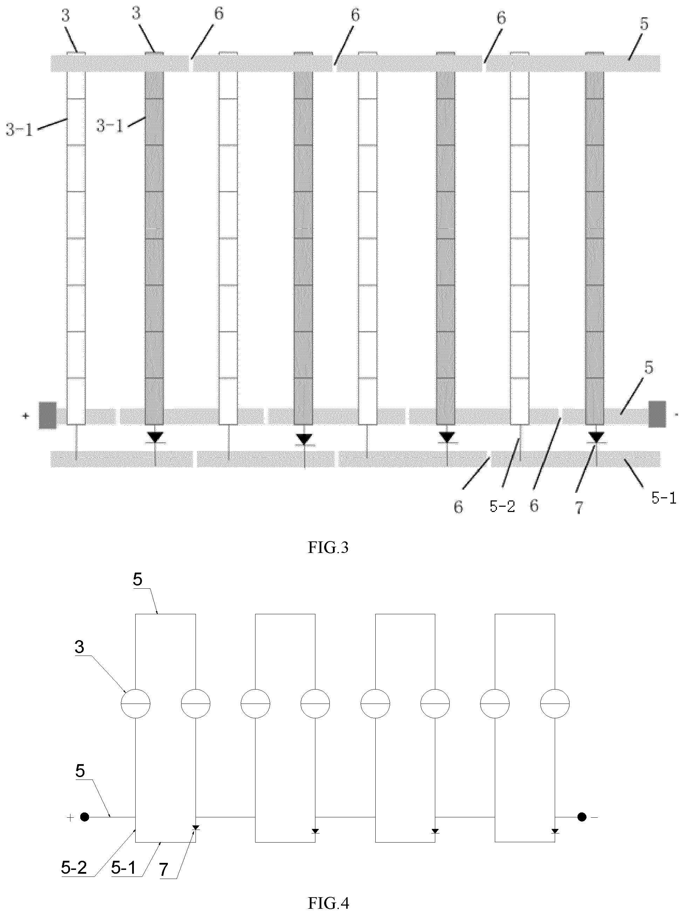

As shown in FIGs. 2-3, this example is basically the same as Example 1, except that the photovoltaic cell string 3 is formed by the photovoltaic cells 3-1 welded in series through imbricating or imbricate welding, the two upward and downward photovoltaic conductive strips 5 of the interconnected photovoltaic generating group are respectively positioned on one side of the shadow surface and one side of the exposal surface of the photovoltaic cell string 3, one end of the photovoltaic cell string 3 is connected with the photovoltaic conductive strip 5 located on its exposal surface through the electrode of the exposal surface of the extreme photovoltaic cell 3-1 of this end, the other end of the photovoltaic cell string 3 is connected with the photovoltaic conductive strip 5 located on its shadow surface through the electrode of the shadow surface of the extreme photovoltaic cell 3-1 of this end.

The photovoltaic cell 3-1 of the photovoltaic cell string 3 is specifically a heterojunction cell of which both front and back surfaces in efficiency as 23.5%.

A manufacturing method of the photovoltaic cell module for Example 2 includes the following steps.

S1. Making the photovoltaic cell string 3, specifically, after welding the photovoltaic cells 3-1 into a string through imbricating or imbricate welding, fragmenting in the first direction by ways of mechanically splintering, dividing a big photovoltaic cell string 3 into independent small photovoltaic cell strings 3, leaving the small photovoltaic cell strings 3 for use in the subsequent step.

S2. Firstly, typesetting the photovoltaic cell string 3 and the photovoltaic conductive strip 5, adjusting the forward-backward orientation (for example, the frontward orientation is upward, and the backward orientation is downward) of the photovoltaic cell string 3 and/or the position of the discontinuous point 6 during typesetting, enabling the discontinuous point 6 to form by ways of punching shear on the photovoltaic conductive strip 5, forming diverse circuit connections between the photovoltaic cell strings 3, next pre-welding the photovoltaic cell string 3 and the bypass diode 7 with the photovoltaic conductive strip 5 to form a semi-finished product.

In Example 2, the photovoltaic cell strings 3 are arranged in the second direction, alternated with one photovoltaic cell string 3 of which the forward surface is upward and the next photovoltaic cell string 3 of which the backward surface is upward.

S3. Then typesetting the rear panel 2, the encapsulation adhesive layer 9, the semi-finished product prepared in S2, the encapsulation adhesive layer 9, and the front panel 1 in proper order, wherein the rear panel 2 is PET or TPT, the encapsulation adhesive layer 9 is EVA or POE or PVB, and the front panel 1 is FRP or ETFE.

S4. Making a photovoltaic cell module through lamination.

### EXAMPLE 3

This example is basically the same as Example 1, except that the metal foil conductive strip is a copper foil strip or aluminum foil strip of which the surface is covered with a 5-100µm thick low-temperature welding material layer, and the flexible flat cable is an FFC cable, FPC cable or PTF cable of which the surface is covered with a low-temperature welding material layer, the welding temperature of the low-temperature welding material layer matches the lamination temperature of the photovoltaic module.

A manufacturing method of the photovoltaic cell module for Example 3 includes the following steps.

S 1. Making the photovoltaic cell string 3.

S2. Firstly laying the rear panel 2 on a typesetting workbench, then laying the encapsulation adhesive layer 9, laying the photovoltaic conductive strip 5 on the encapsulation adhesive layer 9, laying the photovoltaic cell string 3 on the photovoltaic conductive strip 5, adjusting the upward-downward position of the photovoltaic cell string 3 in the first direction and/or the position of the discontinuous point 6, in Example 3, preferably integrating the third photovoltaic conductive strip 5-1 with the photovoltaic conductive strip 5 on the same side into a flexible flat cable, enabling the third photovoltaic conductive strip 5 and the photovoltaic conductive strip 5 on the same side to act as two flexible circuits on the flexible flat cable, welding the bypass diode 7 and the vertical photovoltaic conductive strip 5-2 on this flexible flat cable before typesetting, even enabling the vertical photovoltaic conductive strip 5-2 to act as the flexible circuit on the flexible flat cable, as well as the bypass diode 7 to act as the flexible diode integrated on the flexible flat cable.

S3.Carrying out lamination, under the action of lamination temperature and pressure, combining the connecting portions of the photovoltaic cell string 3 and the photovoltaic conductive strip 5 with each other, forming a mechanical and electrical connection through low-temperature welding material, the low-temperature welding material being inherent in the connecting portions of the photovoltaic cell string 3 and the photovoltaic conductive strip 5, finally obtaining the photovoltaic cell module.

Compared with Example 3, Example 1 can reduce the displacement of the photovoltaic conductive strip 5 pushed by the encapsulation adhesive layer 9 during lamination through pre-welding, compared with Example 1, Example 3 has the advantage of more convenience and lower costs for manufacturing.

Of course, the photovoltaic cell string 3 and the photovoltaic conductive tape 5 can also form a mechanical and electrical connection through the low-temperature curing conductive paste, and the low-temperature curing conductive paste is inherent in the connecting portions of the photovoltaic cell string 3 and the photovoltaic conductive strip 5, or placed on the connecting portion during typesetting, in this way the photovoltaic cell module is finally obtained.

Of course, the photovoltaic cell string 3 and the photovoltaic conductive strip 5 may also form a mechanical and electrical connection through the low-temperature welding material placed on the connection portion during typesetting.

### EXAMPLE 4

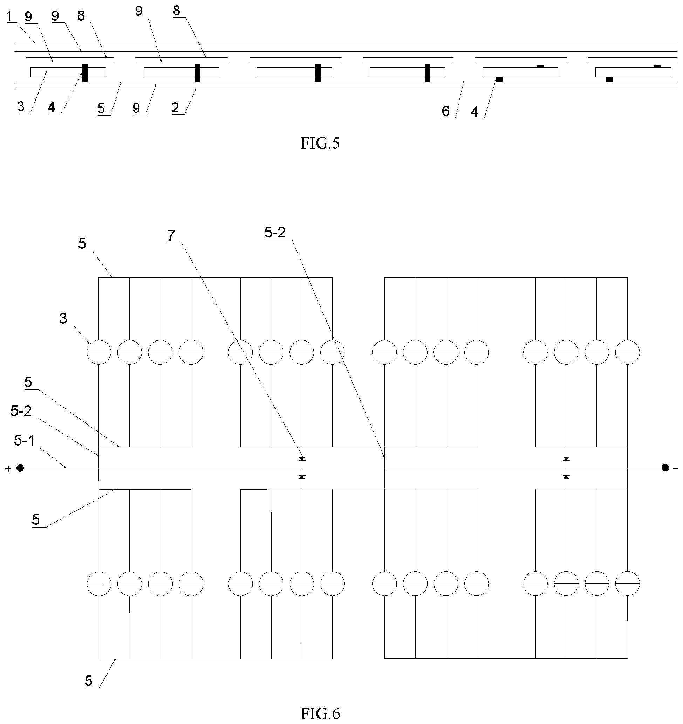

As shown in FIG.5, this example is basically the same as Example 1, except that the photovoltaic cell module is divided into a plurality of rigid minimum folding units arranged in the second direction, and each photovoltaic cell string 3 of the photovoltaic generating group is located in one minimum folding unit, and there is a gap between the minimum folding units. Preferably, the connecting portions of the photovoltaic cell string 3 and the photovoltaic conductive strip 5 are located in the minimum folding unit.

The minimum folding unit is formed by ways of covering the rigid protective plate 8 on one side of the exposal surface of the photovoltaic cell string 3, and the rigid protective plate 8 and the photovoltaic cell string 3 are combined together through the encapsulation adhesive layer 9 between them.

A manufacturing method of the photovoltaic cell module for Example 4 includes the following steps.

S1. Making the photovoltaic cell string 3.

S2. Firstly typesetting the photovoltaic cell string 3 and the photovoltaic conductive strip 5, adjusting the upward-downward position of the photovoltaic cell string 3 in the first direction and/or the position of the discontinuous point 6 during typesetting, enabling the discontinuous point 6 to form by ways of punching shear on the photovoltaic conductive strip 5, forming diverse circuit connections between the photovoltaic cell strings 3, next pre-welding to form a semi-finished product.

S3. Then typesetting the rear panel 2, the encapsulation adhesive layer 9, the semi-finished product prepared in S2, the encapsulation adhesive layer 9, the rigid protective plate 8, the encapsulation adhesive layer 9 and the front panel 1 in proper order.

S4. Making a photovoltaic cell module through lamination.

Of course, in Example 4, the semi-finished product prepared in step S2 can also be covered with the encapsulation adhesive layer 9 and the rigid protective plate 8, and after forming a minimum folding unit, the semi-finished product of S2 is typeset between the front panel 1 and the rear panel 2.

In this example, the minimum folding unit is designed to protect the photovoltaic cells 3-1 within the module when it is flexibly bent and folded, and can be omitted when the module is rigid or when the protection requirement is low.

### EXAMPLE 5

This example is basically the same as Example 4, except that one side of the exposal surface of the photovoltaic cell string 3 is covered with a protective layer of glue-drop material by ways of dropping and curing glue, and the glue-drop material is transparent epoxy resin and the likes, which are a good substitute for the rigid protective plate 8, and directly form a rigid minimum folding unit.

### EXAMPLE 6

This example is basically the same as Example 1, except that the photovoltaic conductive strip 5 is compounded on the encapsulation adhesive layer 9 on its same side. Preferably, the photovoltaic conductive strip 5 is compounded through bonding of a binder.

The structure of the photovoltaic cell module from top to bottom is as follows: the front panel 1, the encapsulation adhesive layer 9, the photovoltaic cell string 3, the encapsulation adhesive layer 9 of the compound photovoltaic conductive strip 5 and the rear panel 2.

Preferably, the surface of the photovoltaic conductive strip 5 has a low-temperature welding material layer, of which the welding temperature matches the lamination temperature of the photovoltaic module. The electrical connection between the photovoltaic cell string 3 and the photovoltaic conductive strip 5 is completed during lamination, as in Example 3.

### EXAMPLE 7

This example is basically the same as Example 6, except that the photovoltaic conductive strip 5 is a conductive paste tape, which is printed by ways of silk-screen printing and compounded on the encapsulation adhesive layer 9. The conductive paste is low-temperature curing conductive paste, of which the curing temperature matches the lamination temperature of the photovoltaic module.

A manufacturing method of the photovoltaic cell module for Example 7 includes the following steps.

S1. Making the photovoltaic cell string 3, preparing the encapsulation adhesive layer 9 compounded with the conductive paste tape.

S2. Firstly, laying the rear panel 2 on a typesetting workbench, then laying the encapsulation adhesive layer 9 compounded with the conductive paste tape, laying the photovoltaic cell string 3 on the photovoltaic conductive strip 5, adjusting the upward-downward position of the photovoltaic cell string 3 in the first direction and/or the position of the discontinuous point 6.

S3.Carrying out lamination, under the action of lamination temperature and pressure, combining the connecting portions of the photovoltaic cell string 3 and the photovoltaic conductive strip 5 with each other, forming a mechanical and electrical connection by ways of curing the low-temperature curing conductive past.

### EXAMPLE 8

This example is basically the same as Example 1, except that the photovoltaic conductive strip 5 is compounded on the rear panel 2 on its same side.

The structure of the photovoltaic cell module from top to bottom is as follows: the front panel 1, the encapsulation adhesive layer 9, the photovoltaic cell string 3, the encapsulation adhesive layer 9 with dodging hollows and the rear panel 2 of the compound photovoltaic conductive strip 5.

Preferably, the electrical connection between the photovoltaic cell string 3 and the photovoltaic conductive strip 5 is completed during lamination, as in Example 3.

### EXAMPLE 9

This example is basically the same as Example 2, except that the photovoltaic conductive strip 5 on one side of the exposal surface is compounded on the encapsulation adhesive layer 9 of the upper layer, and the photovoltaic conductive strip 5 on one side of the shadow surface is compounded on the encapsulation adhesive layer 9 of the lower layer.

The structure of the photovoltaic cell module from top to bottom is as follows: the front panel 1, the encapsulation adhesive layer 9 compounded with the photovoltaic conductive strip 5 on one side of the exposal surface, the photovoltaic cell string 3, the encapsulation adhesive layer 9 compounded with the photovoltaic conductive strip 5 on one side of the shadow surface and of the third photovoltaic conductive strip 5-1, and the rear panel 2.

In example 9, the electrical connection between the photovoltaic cell string 3 and the photovoltaic conductive strip 5 is completed during lamination, as in Example 3.

### EXAMPLE 10

This example is basically the same as Example 1, except that there are N1≥2 photovoltaic generating groups inside the photovoltaic cell layer, the N1≥2 photovoltaic generating groups are arranged in the first direction, and each photovoltaic cell unit inside the photovoltaic generating group is aligned in a row with the photovoltaic cell units at the corresponding position inside other photovoltaic generating groups in the first direction.

The photovoltaic cell module is divided into a plurality of rigid minimum folding units arranged in the second direction, and the photovoltaic cell strings 3 in the same row in the first direction are all located in one minimum folding unit, and there is a gap between the minimum folding units.

Of course, in Example 10, Example 4 and Example 5, it is not excluded that the minimum folding unit is formed by other ways, for example, attaching the rigid protective plate 8 or dropping glue outside the panel 1 to form a rigid minimum folding unit.

As shown in FIG. 6, there are two photovoltaic generating groups in the photovoltaic cell layer, and the two photovoltaic generating groups are symmetrically arranged in the first direction. The photovoltaic cell module is divided into 16 rigid minimum folding units arranged in the second direction.

In order to enable the photovoltaic generating groups composed of a plurality of photovoltaic cell strings 3 to be interconnected with each other through the two upward and downward photovoltaic conductive strips 5 and lead out current, of the photovoltaic cell string 3, one end may be connected with the photovoltaic conductive strip 5 through the interconnecting main gate line 4 stretching out, and the other end may be connected with the photovoltaic conductive strip 5 through the electrodes on the surface of the photovoltaic cell 3-1, in addition, as shown in Example 1, both ends may be connected with the photovoltaic conductive strips 5 through the electrodes on the surface of the photovoltaic cell 3-1, further, as shown in Example 2, both ends may be connected with the photovoltaic conductive strips 5 through the interconnecting main gate line 4 stretching out. In the case that both ends of the photovoltaic cell string 3 are connected with the photovoltaic conductive strips 5 through the interconnecting main gate line 4 stretching out, regardless of which side the photovoltaic conductive strips 5 are positioned at, the interconnecting main gate line 4 stretching out can be connected with the photovoltaic conductive strips 5, so it is not necessary to consider whether the two photovoltaic conductive strips 5 are arranged on the same sides or on divers sides relative to the photovoltaic cell string 3. According to the interconnection form of the photovoltaic cell string 3 itself, the arrangement direction of the two photovoltaic conductive strips 5, and the connection mode of the photovoltaic cell string 3 and the photovoltaic conductive strips 5, it is possible to optionally adjust the upward-downward position of the photovoltaic cell string 3 in the first direction, the two-ends orientation and the forward-backward orientation of the photovoltaic cell string 3, and the discontinuity points 6, so that diverse circuit connections can be formed between the photovoltaic cell strings 3.

Now, we take the case that both ends of the photovoltaic cell string 3 are connected with the photovoltaic conductive strips 5 through the interconnecting main gate line 4 stretching out as an example to further describe the present invention.

### EXAMPLE 11

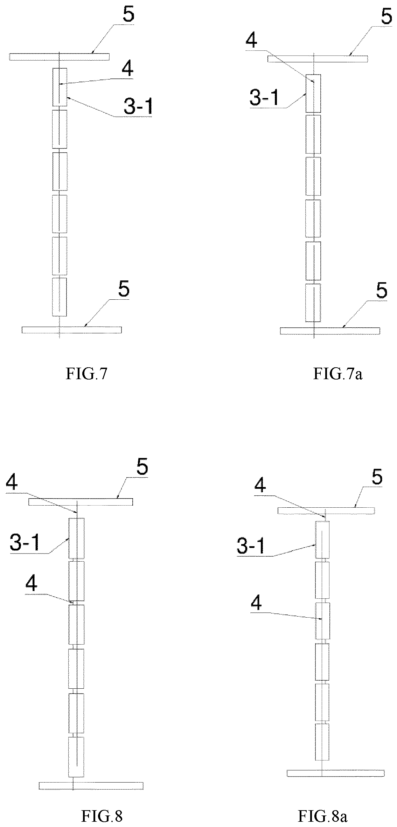

This example is basically the same as Example 1, except that as shown in FIG.7, the photovoltaic cell string 3 is formed by the photovoltaic cells 3-1 welded in series with the antarafacially-interconnected interconnecting main gate line 4, the interconnecting main gate lines 4 connecting the adjacent photovoltaic cells 3-1 are located on the exposal surface of one photovoltaic cell 3-1 and the shadow surface of the adjacent photovoltaic cell 3-1, respectively.

The interconnecting main gate line 4 on the exposal surface of the photovoltaic cell 3-1 at both ends of the photovoltaic cell string 3 stretches to the outside of the photovoltaic cell string 3, the interconnecting main gate line 4 on the shadow surface of the photovoltaic cell 3-1 at both ends of the photovoltaic cell string 3 is located inside the photovoltaic cell string 3, one end of the photovoltaic cell string 3 is welded with the corresponding photovoltaic conductive strip 5 through the interconnecting main gate line 4 stretching out, and the other end of the photovoltaic cell string 3 is welded with the corresponding photovoltaic conductive strip 5 through the electrode on the shadow surface of the extreme photovoltaic cell 3-1 of this end.

As shown in FIG. 7a, just adjusting the two-ends orientation of the photovoltaic cell string 3, that is, turning it through 180 degrees enables divers circuit connections to form between the photovoltaic cell strings 3.

In Example 11, the photovoltaic cell strings 3 are interconnected by ways of conventional antarafacial interconnection, and this method is more suitable for the thicker photovoltaic cell 3-1 because staggeredly welding the photovoltaic cell 3-1 with the interconnecting main gate line 4 will causes fragmentation to the thin photovoltaic cell 3-1. Compared with this example, Example 1 has better compatibility with the thin photovoltaic cell 3-1.

### EXAMPLE 12

This example is basically the same as Example 1, where the photovoltaic cell string 3 is also formed by the photovoltaic cells 3-1 welded in series through the interconnecting main gate lines 4 interconnected on the same surface, except that as shown in FIG.8, the interconnecting main gate line 4 on the exposal surface of the extreme photovoltaic cell 3-1 at the upper end of the photovoltaic cell string 3 stretches to the outside of the photovoltaic cell string 3, the interconnecting main gate line 4 on the shadow surface of the extreme photovoltaic cell 3-1 at the upper end of the photovoltaic cell string 3 is located inside the photovoltaic cell string 3. The upper photovoltaic conductive strip 5 corresponding to the upper end of the photovoltaic cell string 3 is located on one side of the shadow surface of the photovoltaic cell string 3.

The interconnecting main gate line 4 on the exposal surface of the extreme photovoltaic cell 3-1 at the lower end of the photovoltaic cell string 3 is located inside the photovoltaic cell string 3, the interconnecting main gate line 4 on the shadow surface of the extreme photovoltaic cell 3-1 at the lower end of the photovoltaic cell string 3 stretches to the outside of the photovoltaic cell string 3. The lower photovoltaic conductive strip 5 corresponding to the lower end of the photovoltaic cell string 3 is located on one side of the exposal surface of the photovoltaic cell string 3.

As shown in FIG. 8a, just adjusting the two-ends orientation of the photovoltaic cell string 3, that is, turning it through 180 degrees enables divers circuit connections to form between the photovoltaic cell strings 3.

## Claims

1. A photovoltaic cell module comprising a front panel, a rear panel and a photovoltaic cell layer encapsulated between the front panel and the rear panel, wherein the photovoltaic cell layer includes n1 photovoltaic generating groups, each photovoltaic generating group includes n2 photovoltaic cell units arranged in a second direction, the current in the photovoltaic cell unit flows in the first direction perpendicular to the second direction after converging, each photovoltaic generating group is interconnected with each other and leads out current through two upward and downward photovoltaic conductive strips, the two photovoltaic conductive strips are arranged in parallel and stretch in the second direction, the photovoltaic cell units within each photovoltaic generating group are positioned between the two photovoltaic conductive strips, and the two ends of the photovoltaic cell unit are respectively connected with the two photovoltaic conductive strips,
the photovoltaic generating groups are interconnected with each other and leads out current through the photovoltaic conductive strip,
the two photovoltaic conductive strips of the photovoltaic generating group have discontinuous points, which are used to change the series-parallel connection between the photovoltaic cell units within the photovoltaic generating group, where n1≥1, n2≥1.

2. The photovoltaic cell module according to claim 1, wherein the photovoltaic cell unit is a photovoltaic cell string, which is formed by photovoltaic cells welded in series through an interconnecting main gate line, the interconnecting main gate line on one surface of the photovoltaic cells at both ends of the photovoltaic cell string backwards facing a corresponding photovoltaic conductive strip stretches to the outside of the photovoltaic cell string, the interconnecting main gate line on the other surface of the photovoltaic cells at both ends of the photovoltaic cell string frontwards facing a corresponding photovoltaic conductive strip is positioned inside the photovoltaic cell string, one end of the photovoltaic cell string with the connecting portion of the corresponding photovoltaic conductive strip is positioned at the interconnecting main gate line stretching from this end, the other end of the photovoltaic cell string with the connecting portion of the corresponding photovoltaic conductive strip is positioned on the surface of the extreme photovoltaic cell of this end;
or the photovoltaic cell unit is a photovoltaic cell string, which is formed by the photovoltaic cells welded in series through imbricating or imbricate welding, one end of the photovoltaic cell string is connected with the photovoltaic conductive strip through the electrode of the exposal surface of the extreme photovoltaic cell of this end, the other end of the photovoltaic cell string is connected with the photovoltaic conductive strip through the electrode of the shadow surface of the extreme photovoltaic cell of this end.

3. The photovoltaic cell module according to claim 2, wherein the photovoltaic cell in the photovoltaic cell string is made up of small photovoltaic cells divided into by a photovoltaic cell.

4. The photovoltaic cell module according to claim 1, wherein when n1≥2, the photovoltaic generating groups inside the photovoltaic cell layer are arranged in the first direction, and each photovoltaic cell unit in the photovoltaic generating group is aligned in a row with the photovoltaic cell units at the corresponding position inside other photovoltaic generating groups in the first direction.

5. The photovoltaic cell module according to claim 1, wherein the module further includes a bypass diode, which is connected to the photovoltaic generating group through the photovoltaic conductive strip.

6. The photovoltaic cell module according to claim 5, wherein when n1=1, the outside of the photovoltaic conductive strip on one side of the photovoltaic generating group is further provided with a third photovoltaic conductive strip stretching in the second direction, and the bypass diode and a vertical photovoltaic conductive strip stretching in the first direction are connected between the third photovoltaic conductive strip and the photovoltaic conductive strip on the same side, the bypass diode and the vertical photovoltaic conductive strip are aligned with the adjacent photovoltaic cell units in the first direction, the third photovoltaic conductive strip enables the bypass diode to connect to the photovoltaic generating group through its own discontinuous point and the vertical photovoltaic conductive strip stretching in the first direction, the two ends of the photovoltaic conductive strip on the same side as the third photovoltaic conductive strip are positive and negative lead-out ends,
the photovoltaic cell module is a flexible module, the front panel and the rear panel are made from flexible material, and the photovoltaic conductive strip stretching in the second direction is a metal foil conductive strip or a conductive paste tape or a flexible flat cable; or all the photovoltaic conductive strips are a metal foil conductive strip or a conductive paste tape or a flexible flat cable.

7. The photovoltaic cell module according to claim 5, wherein the outside of the photovoltaic conductive strip on one side of the photovoltaic generating group is further provided with a third photovoltaic conductive strip stretching in the second direction, and the bypass diode and a vertical photovoltaic conductive strip stretching in the first direction are connected between the third photovoltaic conductive strip and the photovoltaic conductive strip on the same side, the third photovoltaic conductive strip enables the bypass diode to connect to the photovoltaic generating group through its own discontinuous point and the vertical photovoltaic conductive strip stretching in the first direction.

8. The photovoltaic cell module according to claim 1, wherein the photovoltaic cell layer is encapsulated between the front panel and the rear panel through an encapsulation adhesive layer, and the photovoltaic conductive strip is compounded on the encapsulation adhesive layer on the same side; or the photovoltaic conductive strip is compounded on the front panel or the rear panel on the same side, the encapsulation adhesive layer has a dodging hollow, and the photovoltaic cell unit and the photovoltaic conductive strip are connected with each other through the dodging hollow.

9. The photovoltaic cell module according to claim 1, wherein the photovoltaic cell unit and the photovoltaic conductive strip form a mechanical and electrical connection through low-temperature welding material and low-temperature curing conductive paste, the welding temperature of the low-temperature welding material matches the lamination temperature of the photovoltaic module, and the curing temperature of the low-temperature curing conductive paste matches the lamination temperature of the photovoltaic module.

10. The photovoltaic cell module according to claim 1, or 2, or 3, or 4, or 5, or 7 or 8, or 9, wherein the photovoltaic cell module is a flexible module, the front panel and the rear panel are made from flexible material, and the photovoltaic conductive strip is a metal foil conductive strip or a conductive paste tape or a flexible flat cable.

11. The photovoltaic cell module according to claim 10, wherein the metal foil conductive strip is a copper foil strip or aluminum foil strip of which the surface is covered with a 5-100µm thick low-temperature welding material layer, and the flexible flat cable is an FFC cable, FPC cable or PTF cable of which the surface is covered with a low-temperature welding material layer, the welding temperature of the low-temperature welding material layer matches the lamination temperature of the photovoltaic module.

12. The photovoltaic cell module according to claim 10, wherein the module is divided into a plurality of rigid minimum folding units arranged in the second direction, each photovoltaic cell unit of each photovoltaic generating group is located in one minimum folding unit, and there is a folding gap between the minimum folding units.

13. The photovoltaic cell module according to claim 12, wherein the minimum folding unit is formed by ways of covering a rigid protective plate on one side of the exposal surface of the photovoltaic cell unit, and the rigid protective plate and the photovoltaic cell unit are combined together through the encapsulation adhesive layer between them,
or the minimum folding unit is formed by ways of covering a protective layer of glue-drop material on one side of the exposal surface of the photovoltaic cell unit.

14. A manufacturing method of the photovoltaic cell module according to claim 1, comprising the steps of firstly making a photovoltaic cell unit, then typesetting a photovoltaic cell unit, a photovoltaic conductive strip, a front panel and a rear panel, next making the photovoltaic cell module through lamination,
completing the electrical connection between the photovoltaic cell unit and the photovoltaic conductive strip during lamination, under the action of lamination temperature and pressure, combining the connecting portions of the photovoltaic cell unit and the photovoltaic conductive strip with each other, forming a mechanical and electrical connection through low-temperature welding material or low-temperature curing conductive paste, the low-temperature welding material or the low-temperature curing conductive paste being inherent in the connecting portions of the photovoltaic cell unit and the photovoltaic conductive strip or being placed on the connecting portion during typesetting,
or the steps of firstly making a photovoltaic cell unit, then typesetting a photovoltaic cell unit and a photovoltaic conductive strip and pre-welding to form a semi-finished product, next typesetting the semi-finished product, a rear panel and a front panel, next making the photovoltaic cell module through lamination.

15. The manufacturing method according to claim 14, wherein when the photovoltaic cell unit is a photovoltaic cell string, the photovoltaic cell string is formed by photovoltaic cells welded in series through interconnecting main gate lines, the interconnecting main gate line on one surface of the photovoltaic cells at both ends of the photovoltaic cell string backwards facing a corresponding photovoltaic conductive strip stretches to the outside of the photovoltaic cell string, the interconnecting main gate line on the other surface of the photovoltaic cells at both ends of the photovoltaic cell string frontwards facing a corresponding photovoltaic conductive strip is positioned inside the photovoltaic cell string, one end of the photovoltaic cell string with the connecting portion of the corresponding photovoltaic conductive strip is positioned at the interconnecting main gate line stretching from this end, the other end of the photovoltaic cell string with the connecting portion of the corresponding photovoltaic conductive strip is positioned on the surface of the extreme photovoltaic cell of this end;
adjusting the upward-downward position of the photovoltaic cell string in the first direction and/or the position of the discontinuous point during typesetting enables diverse circuit connections to form between the photovoltaic cell strings;
or when the photovoltaic cell unit is a photovoltaic cell string, the photovoltaic cell string is formed by the photovoltaic cells welded in series through imbricating or imbricate welding, one end of the photovoltaic cell string is connected with the photovoltaic conductive strip through the electrode of the exposal surface of the extreme photovoltaic cell of this end, the other end of the photovoltaic cell string is connected with the photovoltaic conductive strip through the electrode of the shadow surface of the extreme photovoltaic cell of this end,
adjusting the forward-backward orientation of the photovoltaic cell string and/or the position of the discontinuous point during typesetting enables diverse circuit connections to form between the photovoltaic cell strings.

16. The manufacturing method according to claim 15, wherein after welding the photovoltaic cells into a string, fragmentation is carried out in the first direction, a big photovoltaic cell string is divided into independent small photovoltaic cell strings, leaving the small photovoltaic cell strings for use in the subsequent step of typesetting.
